# EUROPEAN PATENT APPLICATION

(11) **EP 3 882 962 A1**
(43) Date of publication of application: **22.09.2021**
(21) Application number: 20164201.4
(22) Date of filing: 19.03.2020
(51) Int. Cl.: H01L 21/8238

(54) **METHOD FOR FABRICATING A CMOS DEVICE**

(71) Applicant: IMEC VZW, 3001 Leuven (BE)
(72) Inventor: KIM, Min-Soo, 3001 Leuven (BE); TAO, Zheng, 3001 Leuven (BE); LI, Waikin, 3001 Leuven (BE); SEBAAI, Farid, 3001 Leuven (BE); LORANT, Christophe, 3001 Leuven (BE)
(74) Representative: Roth, Sebastian

(57) **Abstract**

The present disclosure relates generally to the field of semiconductor processing, and particularly provides a method for fabricating a Complementary Metal Oxide Semiconductor (CMOS) device. A method of the present disclosure specifically provides a sequence of fabricating an n-type well and a p-type well of the CMOS device, which sequence enables a subsequent uniform growth of channel structures on the n-type and p-type wells. The method comprises: growing a semiconductor substrate, forming a first mask structure on the substrate, inserting n-type dopants into a first surface region of the substrate to form an n-type well, wherein the first mask structure prevents insertion of n-type dopants into a second surface region of the substrate, and removing the first mask structure. The method thereafter comprises forming a second mask structure on the substrate, inserting p-type dopants into the second surface region of the substrate to form a p-type well, wherein the second mask structure prevents insertion of p-type dopants into the first surface region of the substrate, and removing the second mask structure. Further, the method comprises growing one or more vertical semiconductor channel structures simultaneously on the n-type well and the p-type well.

## Description

### TECHNICAL FIELD

The present disclosure relates generally to the field of semiconductor processing, and particularly provides a method for fabricating a Complementary Metal Oxide Semiconductor (CMOS) device. For instance, the method may be used for fabricating a vertical CMOS device. The present disclosure specifically provides a sequence of fabricating an n-type well and a p-type well of the CMOS device, which sequence enables a subsequent uniform growth of channel structures on the n-type and p-type wells.

### BACKGROUND OF THE INVENTION

For fabricating and scaling vertical) CMOS devices, particularly Static Random Access Memory (SRAM) devices, epitaxial growth of silicon may be used to form one or more (vertical) semiconductor channel structures. These semiconductor channel structures may, for example, be simultaneously grown on a previously fabricated n-type well and p-type well, which are adjacently arranged, and which later act as a source and drain to each channel provided by the channel structures, respectively, in the final CMOS device.

Forming the n-type well and the p-type well, respectively, typically requires rather high implantation doses for the implantation of n-type dopants and p-type dopants. Therefore, a hard mask based technique may be preferred for the well formation over scum-prone photo resist based techniques.

However, in order to form an n-type well and a p-type with an abutting n/p boundary while using such a hard mask technique, requires to precisely create and remove respective hard mask structures and layers. For instance, the hard mask structures and layers may be remove by etching.

Moreover, a uniform epitaxial growth is required for forming simultaneously the multiple semiconductor channel structures, in particular, to obtain ideally the same critical dimension (CD) for each of the channel structures. For example, the multiple vertical semiconductor channel structures should ideally all have the same height, or at least they should have heights that do not substantially differ from another.

In this respect, it is a technological challenge to fabricate the n-type well and the p-type well using a hard mask technique, and to further fabricate the channel structures on these wells.

### SUMMARY OF THE INVENTION

In view of the above-mentioned challenges, embodiments of the present invention aim to provide an improved method for fabricating a CMOS device, which includes vertical semiconductor channel structures. In particular, the method should enable the formation of the multiple semiconductor channel structures in parallel, wherein all semiconductor channel structures have the same CD.

In an attempt to address this challenge, the inventors generally proposed applying a Spin Cleaning with Repeated Ozonized water and Diluted HF (SCROD) method, in order to remove layers of respective hard mask structures used during the n-type well and p-type well formations. However, the inventors found that the applied SCROD method etches in different amounts into the (usually heavily doped) n-type semiconductor material (e.g., silicon) of the n-type well, and the p-type semiconductor material (e.g., silicon) of the p-type well. In particular, it was observed that the etch rate is higher on the n-type material than on the p-type material. The inventors attributed this difference to different amounts of damage and surface containments, which are introduced during the fabrication of the n-type well and the p-type well. In particular, damages caused by using additionally plasma etching for removing layers of hard mask structures, and damages cause by ion implantation used for implanting the respective n-type and p-type dopants into the semiconductor material.

In the first attempt, the p-type well was formed before the n-type well (referred to as "pMOS-first" process). The difference in the etch rate of the n/p semiconductor material resulted in a non-uniform epitaxial growth of the semiconductor channel structures across the n/p boundary of adjacent n-type/p-type wells. The nonuniformity was proportional to the different amounts of material loss on the n-type and p-type well surfaces, respectively, during the hard mask (layer) removal(s). In particular, a height difference (i.e., a step) of about 7 nm was observed between the adjacent n-type and p-type well surfaces. Such a height difference can impact the performance of the final CMOS device, due to the resulting differences in the CD of the various semiconductor channel structures.

Indeed, following the analysis of the inventors of the first attempt, there was the desire to provide an alternative that enables better (i.e., more uniform) epitaxial growth of the channel structures across the n/p boundary of formed by the n-type well and the p-type well, in particular, that results in a smaller height differences between the various epitaxially grown channel structures.

Accordingly, it is an objective to form an n-type well and p-type well, respectively, with a reduced and/or negligible (e.g., less than 5 nm) height difference (i.e., step) between the adjacent n/p well surfaces.

The objective is achieved by the embodiments of the invention as provided in the enclosed independent claims. Advantageous implementations of these embodiments are defined in the dependent claims.

In particular, it was surprisingly found by the inventors that the well formation sequence impacts the step height, the uniformity of the epitaxial growth on top of the n/p-type wells, and thus the CD of the channel structures in the final CMOS device. Accordingly, based on new learning and process data, the first attempt was changed to a sequence of fabricating the n-type well first, i.e. before the p-type well (referred to as "nMOS-first" process). This swap reduced significantly the difference in the loss of semiconductor material (e.g., silicon) between the n-type and p-type well surfaces during the hard mask structure removal, in particular, by more than 50% compared to the pMOS-first process (e.g., to a step of 3 nm or less at the n/p boundary of the n-type well and p-type well). This consequently resulted in a significantly improved CD of the semiconductor channel structures, in particular, resulted in a reduced height difference (e.g., less than 1 nm difference) between the different vertical semiconductor channel structures.

A first aspect of the invention provides a method for processing a CMOS device, the method comprising: growing a semiconductor substrate; forming a first mask structure on the substrate; inserting n-type dopants into a first surface region of the substrate to form an n-type well, wherein the first mask structure prevents insertion of n-type dopants into a second surface region of the substrate; removing the first mask structure; thereafter forming a second mask structure on the substrate; inserting p-type dopants into the second surface region of the substrate to form a p-type well, wherein the second mask structure prevents insertion of p-type dopants into the first surface region of the substrate; removing the second mask structure; and growing one or more vertical semiconductor channel structures simultaneously on the n-type well and the p-type well.

An advantage of the method of the first aspect is that it can be performed at low temperatures (e.g., at room temperature), which makes it compatible with future advanced technology node requirements (e.g., for vertical devices, 3D sequential, SiGe, Ge, or for growing III-V channel material that often requires low temperature), and resolves issues of surface treatment for the epitaxial growth on both the n-type and p-type well. In particular, the method of the first aspect results in the above-mentioned smaller step at the n/p boundary of the wells, the more uniform epitaxial growth of the semiconductor channel structures, and the accordingly improved CD of the semiconductor channel structures.

As a consequence, the method of the first aspect enables fabricating and scaling vertical SRAM devices using vertical a Gate-All-Around (GAA) transistor architecture, wherein a CMOS compatible channel epitaxial growth is used.

In an implementation of the method, removing the first mask structure and/or the second mask structure comprises performing a SCROD method.

This is beneficial for the hard mask technique based approach of the method of the first aspect, and allows creating extremely small height difference between the n-type well and the p-type well.

In an implementation of the method, the n-well and the p-well are formed adjacently; and a surface step between the surface of the n-well and the adjacent surface of the p-well is in a range of 1-3 nm.

This provides much more similar CD of the channel structures.

In an implementation of the method, the first mask structure comprises a first pad oxide provided on the substrate; a pad nitride provided on the first pad oxide above the second surface region of the substrate; and a first hard mask oxide provided on the pad nitride.

In an implementation of the method, the second mask structure comprises a second pad oxide provided on the substrate; and a second hard mask oxide provided on the second pad oxide above the first surface region of the substrate.

In an implementation of the method, the first pad oxide and the first hard mask oxide, and/or the second pad oxide and the second hard mask oxide, are removed by performing the SCROD method.

In an implementation of the method, a thickness of the first pad oxide is smaller than a thickness of the second pad oxide.

This is a result of the nMOS-first process employed by the method of the first aspect, and results in the decreased height difference (step) between the n-type and p-type well surfaces.

In an implementation of the method, the n-type dopants and/or the p-type dopants are inserted into the substrate by ion implantation.

In an implementation of the method, the n-type dopants are ion implanted into the first surface region of the substrate through the first pad oxide; the p-type dopants are ion implanted into the second surface region of the substrate through the second pad oxide; and the ion implantation doses and/or energies for the n-type dopants and the p-type dopants are, respectively, selected based on the thickness of the first pad oxide and the thickness of the second pad oxide, to obtain an equal depth profile of the n-dopants in the n-well and the p-dopants in the p-well.

This is a consequence of the nMOS-first process, and allows achieving the advantages of the nMOS-first process described above.

In an implementation of the method, the one or more vertical semiconductor channel structures comprise one or more vertical semiconductor nanowires or nanowire pillars.

The vertical nanowires or pillars can be grown such, that they have all the same height (e.g., within 1 nm or less), which is a result of the nMOS-first process and the accordingly reduced height difference between the n-type and p-type well surfaces, respectively.

In an implementation of the method, the semiconductor substrate is a silicon substrate or a silicon-based substrate.

In an implementation of the method, each of the one or more vertical semiconductor channel structures comprises a channel made of silicon, silicon germanium, germanium, or a III-V semiconductor material.

In an implementation of the method, the vertical CMOS device is a 3D SRAM device; and/or the vertical CMOS device is a SGT-SRAM device, wherein each of the one or more vertical semiconductor channel structures is surrounded by at least one gate structure.

A second aspect of the invention provides a CMOS device fabricated using the method according to the first aspect any implementation form thereof.

The CMOS device of the second aspect achieves the same advantages as the method of the first aspect and the respective implementations as described above. The CMOS device of the second aspect may be a vertical CMOS device, for instance, it maybe 3D SRAM device or SGT-SRAM device.

### BRIEF DESCRIPTION OF THE DRAWINGS

The above described aspects and implementations are explained in the following description of embodiments with respect to the enclosed drawings, wherein:
- FIG. 1: shows steps (a) - (d) of a method for fabricating a CMOS device according to an embodiment of the invention.
- FIG. 2: shows steps (e) - (h) of the method of FIG. 1 for fabricating a CMOS device according to an embodiment of the invention.
- FIG. 3: shows steps of an exemplary method according to an embodiment of the invention, for fabricating a vertical SGT-SRAM device.
- FIG. 4: shows further steps of an exemplary method according to an embodiment of the invention, for fabricating a vertical SGT-SRAM device.

### DETAILED DESCRIPTION OF EMBODIMENTS OF THE INVENTION

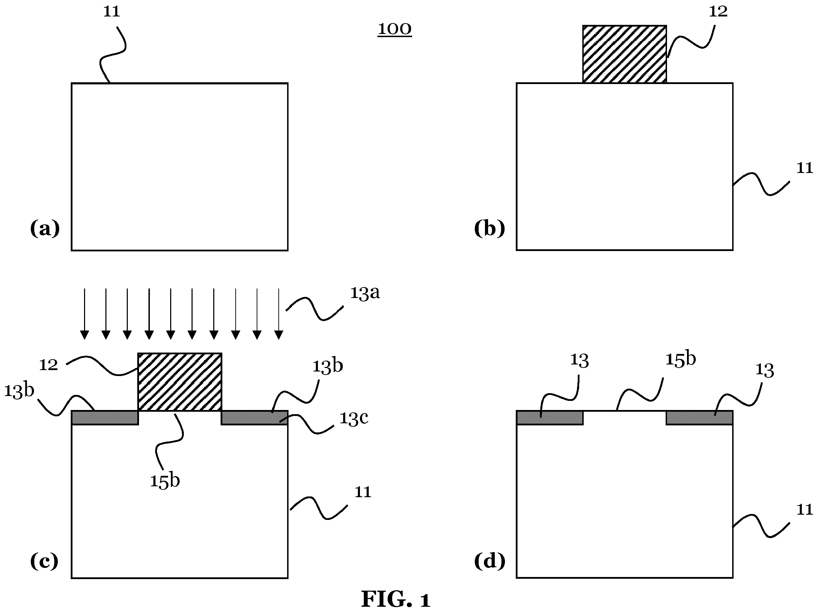

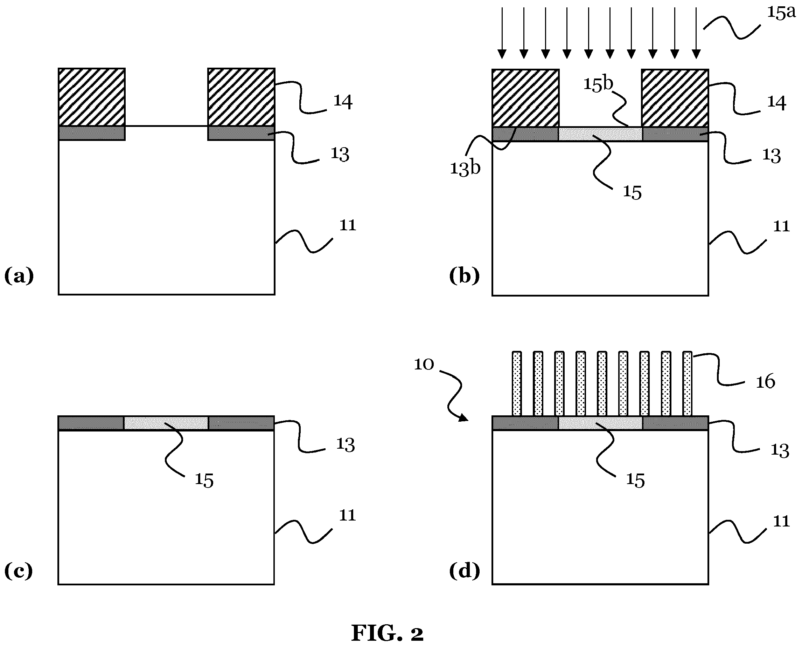

FIG. 1 and FIG. 2 show a method 100 according to an embodiment of the invention. The method 100 can be used to fabricate a CMOS device 10, as based on the structure shown in FIG. 2(h), which structure maybe further processed, e.g. into a vertical CMOS device and/or into a 3D SRAM device and/or into SGT-SRAM device. That is, the method 100 is suitable for fabricating all of these vertical CMOS devices.

FIG. 1(a) shows that first a semiconductor substrate 11 is grown, for instance, epitaxially. The substrate 11 may be a silicon or silicon-based substrate, and may comprise differently doped layers. For example, a top-layer of the substrate 11 may be an intrinsic silicon layer, or the top layer of the substrate 11 may be a (e.g., moderately) doped n-type or p-type layer of semiconductor material.

FIG. 1(b) shows that then a first mask structure 12 is formed on the grown substrate 11. In particular, the first mask structure 12 may be a first hard mask (structure). The first mask structure 12 may comprise one or more mask layers, e.g., it may comprise one or more oxide layers and/or one or more nitride layers. The first mask structure 12 may comprise multiple separate mask structure parts (here two are shown), which may be formed in the same process.

FIG. 1(c) shows a subsequent step of inserting n-type dopants 13a into a first surface region 13b of the substrate 11, in order to form an n-type well 13 (also referred to as "n-well"). For instance, the n-type dopants 13a may be (ion) implanted into the first surface region 13b. Multiple n-type wells 13 may be formed in this way, here exemplarily two n-type wells 13 are shown. During the n-type well(s) 13 formation, the first mask structure 12 is configured/structured such that it prevents insertion/implantation of n-type dopants 13a into a second surface region 15b of the substrate 11 (which may comprise multiple second surface region parts). The first mask structure 12 may, to this end, be formed at least above/on the second surface region 15b of the substrate 11. If parts of the first mask structure 12 are formed also on other regions of the substrate 11, e.g. on the first surface region 13b, then these parts may be formed such that inserting dopants through these parts into the substrate 11 is possible.

FIG. i(d) shows a step of removing the first mask structure 12. For instance, the removing of the first mask structure 12 may comprises performing a SCROD method, e.g., performing one or more sequences of SCROD. Each sequence may remove a certain thickness of the first mask structure 12. One or more mask layers of the first mask structure 12 maybe removed by the SCROD method. One or more other mask layers of the first mask structure 12 may, in addition, be removed by plasma etching or the like. Removing the first mask structure 12 may, in the end, leave at least the second surface region 15b of the substrate 11 exposed.

FIG. 2(a) shows that after removing the first mask structure 12, a second mask structure 14 is formed on the substrate 11. The second mask structure 14 may be a second hard mask. The second mask structure 14 may comprise one or more mask layers, e.g., one or more oxide layers and/or one or more nitride layers. The second mask structure 14 may be formed at least above/on the first surface region 13b of the substrate 11. If parts of the second mask structure 12 are formed also on other regions of the substrate 11, e.g. on the second surface region 15b, then these parts may be formed such that inserting dopants through these parts into the substrate 11 is possible.

FIG 2(b) shows a step of inserting p-type dopants 15a into the second surface region 15b of the substrate 11 to form a p-type well 15 (also referred to as "p-well"). The p-type dopants 15a may be (ion) implanted into the substrate 11. Multiple p-type wells 15 may be formed in this way, here exemplarily only one p-type wells 15 is shown During this p-type well(s) formation, the second mask structure 14 is configured/structures such that it prevents insertion/implantation of p-type dopants 15a into the first surface region 13b of the substrate (i.e., into the n-type well 13). The n-type well 13 and the p-type well 15 may be formed adjacently, but can also be distanced. Thereby, a surface step between the surface of the n-type well 13 and the adjacent surface of the p-type well 15 may - if there is one at all - be in a range of 1-3 nm or less. That is, any such step may be significantly smaller than when the pMOS-first process is used.

FIG. 2(c) shows a step of removing the second mask structure 14. For instance, removing the second mask structure 15 may comprises performing a SCROD method, e.g., may comprise performing one or more sequences of SCROD. Each sequence may remove a certain thickness of the second mask structure 14. One or more mask layers of the second mask structure 14 may be removed by the SCROD method. One or more other mask layers of the second mask structure 14 may, in addition, be removed by plasma etching or the like. Removing the second mask structure 14 may leave at least the n-type well(s) 13 and p-type well(s) 15 exposed.

FIG. 2(d) shows a step of, thereafter, forming one or more vertical semiconductor channel structures 16, simultaneously, on the n-type well 13 and the p-type well 15. The one or more vertical semiconductor channel structures 16 may comprise one or more vertical semiconductor nanowires or nanowire pillars. Further, each of the one or more vertical semiconductor channel structures 16 may comprise a channel made of silicon, silicon germanium, germanium, or a III-V semiconductor material. The channel structures 16 may all have the same height, or may differ in height by 1 nm or less.

In the above-shown method 100, one or more SCROD sequences of the SCROD method may be performed as described. The SCROD method may thereby be performed at room temperature, and may be performed to remove parts or certain mask layers of the first and/or second mask structure(s) 12 and/or 14, which are respectively arranged over the n-type well 13 and/or p-type well 15 during the well formation(s). In particular, one or more oxide layers of the first mask structure 12 and/or one or more oxide layers of the second mask structure 14 may, respectively, be removed by performing one or more sequences of the SCROD method. In addition, one or more nitride layers of the first mask structure 12 and/or or one or more nitride layers of the second mask structure 14 may be removed by additionally performing plasma etching or the like. The SCROD method and the plasma etching can thereby be performed alternatingly, or in any order or sequence.

During the performing of the SCROD method, a retardation of the oxide etch rate (of one or more oxide layers of the mask structures 12/14) was observed, as the etching reaches near the substrate 11. Further, it was observed that the SCROD method etches different amounts of material of the substrate 11 (e.g., silicon) depending on whether it is of the n-type and the p-type. For instance, when an oxide layer of the first hard mask 12 is removed from directly on the n-type well, the substrate material loss may be different than when an oxide layer of the second hard mask 14 is removed from directly on the p-type well 15. Thus, a height difference or step may be formed between one or more n/p boundaries of adjacent n-type well(s) 13 and p-type well(s) 15 surfaces.

This may yield a different epitaxial thickness, when epitaxial structures are grown above/on the n-type well 13 and the p-type well 15, respectively, after the mask structure removal(s). For example, when the semiconductor channel structures 16 are grown. This thickness difference may further manifest in an inhomogeneous CD of these semiconductor channel structures 16, for instance, different heights of semiconductor nanowires or nanopillars grown (e.g., based on silicon) simultaneously across the one or more n/p boundaries. The different CDs may affect the CMOS device performance (e.g., it may affect a threshold voltage Vt, or an on-current Ion and/or an off-current Ioff of one or more transistors of the CMOS device. The height difference of, for example, the nanowires or nanopillars, may further pose challenges of process control and process stability on any downstream process, i.e., any process that further processes these semiconductor channel structures 16. Notably, the retarded oxide etch rate and/or the different amounts of substrate material removed by the SCROD method, are attributed to plasma etch damage and/or ion implantation damage.

Swapping the formation of the p-type well 15 and the n-type well 13, i.e., implementing an nMOS-first process, mitigates or even completely eliminates the problem. While the swap from the pMOS-first process does not change the amount of the damages (caused by e.g. plasma etching and/or ion implementation), the nMOS-first process reduces significantly the difference in the amount of substrate (e.g., silicon) removed by the SCROD method, i.e., it reduces the step formed between the n-type well 13 and the p-type well 15 surfaces. This leads to a reduced height differences (e.g., only between 1-3 nm) at the n/p boundary, and consequently yields a much more uniform epitaxial growth on top of the n-type/p-type wells 13 and 15, of the semiconductor channel structures 16.

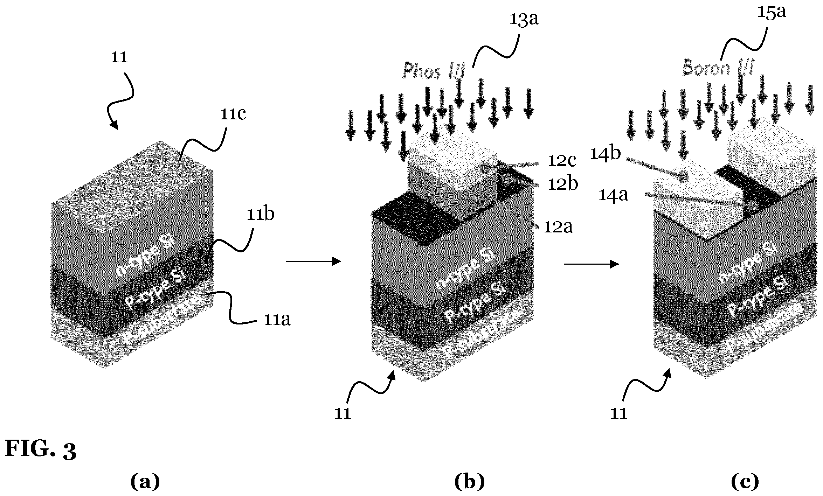

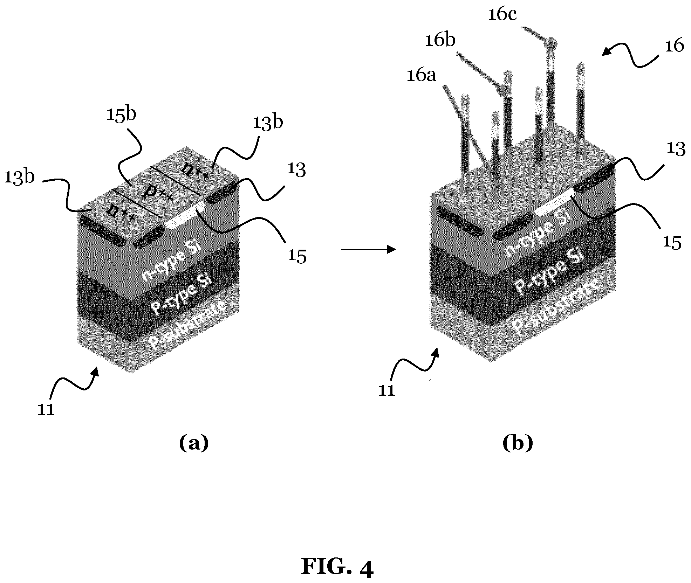

FIG. 3 and FIG. 4 show the method 100 according to an embodiment of the invention, which builds on the embodiment shown in FIG. 1 and FIG. 2. FIG. 3 and FIG. 4 exemplarily show a method for fabricating a vertical SGT-SRAM device 10.

FIG. 3(a) shows that again first the substrate 11 is provided, e.g. grown. The substrate 11 here includes three substrate layers, a p-type silicon substrate 11a, a p-type silicon layer 11b provided on the p-type silicon substrate 11a, and an n-type silicon layer 11c provide don the p-type silicon layer 11b. Conductivity types of these doped layers could also be reversed.

FIG. 3(b) shows that then the first mask structure 12 is formed on the substrate 11. Here, the first mask structure 12 comprises a first pad oxide 12a, which is provided on the entire surface of the substrate 11, a pad nitride 12b provided on the first pad oxide 12a only above the second surface region 15b of the substrate 11, and a first hard mask oxide 12c provided on the pad nitride 12b. Further, FIG. 3(b) shows that ion implantation of e.g. phosphor (as the n-type dopants 13a) maybe performed to form the n-type well 13 in the surface region 13b of the n-type silicon layer 11c of the substrate 11.

Afterwards, the first mask structure 12 is removed (here not shown). Thereby, the SCROD method may be used to remove the first hard mask oxide 12c and the pad oxide 12a, and additionally plasma etching may be used to remove the pad nitride 12b.

FIG. 3(c) shows that then the second mask structure 14 is formed. Here, the second mask structure 14 comprises a second pad oxide 14a provided on the entire surface of the substrate 11, and a second hard mask oxide 114b provided on the second pad oxide 14a only above the first surface region 13b. Further, ion implantation of e.g. boron (as the p-type dopants 15a) may be performed to form the p-type well 15 in the second surface region 15b of the n-type silicon layer 11c of the substrate 11.

Afterwards, the second mask structure 12a is removed. Thereby, the SCROD method may be used to remove the second hard mask oxide 14b and the second pad oxide 14a (here not shown).

FIG. 4(a) shows that after the removal of the second mask structure 12a, the substrate surface, in particular the surfaces of the n-type well 13 (the first surface region 13b) and the p-type well 15 (the second surface region 15b) are exposed. Here, the wells 13 and 15 are heavily doped, i.e., are n++ and p⁺⁺ wells, respectively.

FIG. 4(b) shows that thereafter the plurality of semiconductor channel structures 16 may be formed on the substrate surface, i.e. on the n-type well 13 and p-type well 15 respectively. The channel structures 16 are formed on both the n-type well 13 and the p-type well 15, i.e., they are formed across the n/p boundary. Multiple such n/p boundaries may exist. The channel structures 16 may be grown simultaneously by epitaxy, or an epitaxy layer may be grown and then structured into the channel structures 16. Here, the channel structures 16 are shown to be vertical nanowires or nanopillars. Exemplarily, each of these nanowires 16 includes a semiconductor pillar 16a (e.g. a silicon pillar), an oxide layer 16b and a nitride layer 16c.

The structure shown in FIG. 4(b) may be further processed to form the final SGT-SRAM device (here not shown). For instance, the further processing steps may include surrounding each of the vertical channel structures 16 by at least one gate structure. Furthermore, the further processing steps may include structuring a bottom connection to the vertical channel structures 16, in order to make the n-type well 13 and the p-type well 15 function as source and drain contacts for the channel structures 16, respectively. Thus, the method 100 may further fabricate vertical GAA transistors.

In summary, the advantages of the embodiments of the invention include that they can be fabricated at low temperatures. Further, that the surfaces of the n-type well(s) 13 and p-type well(s) are optimized for further epitaxial growth. Application scenarios of the embodiments of the invention include SRAM devices, in particular, using vertical GAA transistor architectures.

## Claims

1. A method (100) for processing a Complementary Metal-Oxide-Silicon, CMOS, device, (10) the method (100) comprising:
growing a semiconductor substrate (11);
forming a first mask structure (12) on the substrate (11);
inserting n-type dopants (13a) into a first surface region (13b) of the substrate (11) to form an n-type well (13), wherein the first mask structure (12) prevents insertion of n-type dopants (13a) into a second surface region (15b) of the substrate (11);
removing the first mask structure (12);
thereafter forming a second mask structure (14) on the substrate (11);
inserting p-type dopants (15a) into the second surface region (15b) of the substrate (11) to form a p-type well (15), wherein the second mask structure (14) prevents insertion of p-type dopants into the first surface region (13b) of the substrate (11);
removing the second mask structure (14); and
growing one or more vertical semiconductor channel structures (16) simultaneously on the n-type well (13) and the p-type well (15).

2. The method (100) according to claim 1, wherein:
removing the first mask structure (12) and/or the second mask structure (14) comprises performing a Spin Cleaning with Repeated Ozonized water and Diluted HF, SCROD, method.

3. The method (100) according to claim 1 or 2, wherein:
the n-well (13) and the p-well (15) are formed adjacently; and
a surface step between the surface of the n-well (13) and the adjacent surface of the p-well (15) is in a range of 1-3 nm.

4. The method (100) according to one of the claims 1 to 3, wherein the first mask structure (12) comprises:
a first pad oxide (12a) provided on the substrate (11);
a pad nitride (12b) provided on the first pad oxide (12a) above the second surface region (15b) of the substrate (11); and
a first hard mask oxide (12c) provided on the pad nitride (12b).

5. The method (100) according to one of the claims 1 to 4, wherein the second mask structure (14) comprises:
a second pad oxide (14a) provided on the substrate (11); and
a second hard mask oxide (14b) provided on the second pad oxide (14a) above the first surface region (13b) of the substrate (11).

6. The method (100) according to the claims 3, 4 and 5, wherein:
the first pad oxide (12a) and the first hard mask oxide (12c), and/or the second pad oxide (14a) and the second hard mask oxide (14b), are removed by performing the SCROD method.

7. The method (100) according to the claims 4 and 5, or according to claim 6, wherein:
a thickness of the first pad oxide (12a) is smaller than a thickness of the second pad oxide (14a).

8. The method (100) according to one of the claims 1 to 7, wherein:
the n-type dopants (13a) and/or the p-type dopants (15a) are inserted into the substrate (11) by ion implantation.

9. The method (100) according to claims 7 and 8, wherein:
the n-type dopants (13a) are ion implanted into the first surface region (13b) of the substrate (11) through the first pad oxide (12a);
the p-type dopants (15a) are ion implanted into the second surface region (15b) of the substrate (11) through the second pad oxide (14a); and
the ion implantation doses and/or energies for the n-type dopants (13) and the p-type dopants (15) are, respectively, selected based on the thickness of the first pad oxide (12a) and the thickness of the second pad oxide (14a), to obtain an equal depth profile of the n-dopants (13a) in the n-well (13) and the p-dopants (15a) in the p-well (15).

10. The method (100) according to one of the claims 1 to 9, wherein:
the one or more vertical semiconductor channel structures (16) comprise one or more vertical semiconductor nanowires or nanowire pillars.

11. The method (100) according to one of the claims 1 to 10, wherein:
the semiconductor substrate (11) is a silicon substrate or a silicon-based substrate.

12. The method (100) according to one of the claims 1 to 11, wherein:
each of the one or more vertical semiconductor channel structures (16) comprises a channel made of silicon, silicon germanium, germanium, or a III-V semiconductor material.

13. The method (100) according to one of the claims 1 to 12, wherein:
the CMOS device (10) is vertical CMOS device and/or a 3D Static Random Access Memory, SRAM device; and/or
the CMOS device is a vertical CMOS device and/or a Surrounding Gate Transistor SRAM, SGT-SRAM, device, wherein each of the one or more vertical semiconductor channel structures (16) is surrounded by at least one gate structure.

14. A CMOS device (10) fabricated using the method (100) according to any one of the claims 1 to 13.
